Europäisches Patentamt

European Patent Office

Office européen des brevets

(19)

(11) Veröffentlichungsnummer: **0 179 459 B1**

## EUROPÄISCHE PATENTSCHRIFT

(12)

(45) Veröffentlichungstag der Patentschrift: **04.03.92**

(21) Anmeldenummer: **85113467.6**

(22) Anmeldetag: **23.10.85**

(51) Int. Cl.$^5$: **H03H 9/02**, H03H 9/145, H03H 9/64

(54) Mit akustischen Wellen arbeitendes elektrisches Filter.

(30) Priorität: **26.10.84 DE 3439340**
**11.07.85 DE 3524825**

(43) Veröffentlichungstag der Anmeldung:
**30.04.86 Patentblatt 86/18**

(45) Bekanntmachung des Hinweises auf die
Patenterteilung:
**04.03.92 Patentblatt 92/10**

(84) Benannte Vertragsstaaten:
**AT BE CH DE FR GB IT LI NL SE**

(56) Entgegenhaltungen:
**EP-A- 0 074 252**
**EP-A- 0 098 579**

**ELECTRONICS LETTERS, Band 8, Nr. 20, 5.
Oktober 1972, Seiten 493,494; W.H. HAYDL:
"Apodised surface-wave transducers"**

(73) Patentinhaber: **SIEMENS AKTIENGESELL-
SCHAFT
Wittelsbacherplatz 2
W-8000 München 2(DE)**

(72) Erfinder: **Ehrmann-Falkenau, Ekkehard, Dr.
Alfred-Neumann-Anger 14
W-8000 München 83(DE)**
Erfinder: **Veith, Richard, Dipl.-Phys.
Habichtstrasse 56
W-8025 Unterhaching(DE)**
Erfinder: **Till, Wolfgang, Dipl.-Math.
Richard-Strauss-Strasse 79
W-8000 München 80(DE)**

EP 0 179 459 B1

**Beschreibung**

Die vorliegende Erfindung bezieht sich auf ein Filter nach dem Oberbegriff des Patentanspruchs 1.

Es ist bekannt, in der Elektrotechnik mit elastischen akustischen Wellen arbeitende Filter zu verwenden. Insbesondere sind dies Oberflächenwellen-Filter. Allgemein sind solche Filter beschrieben in Mathews "Surface Wave Filters" J. Wiley & Sons, New York.

Ein derartiges Filter ist auf einem vorzugsweise piezoelektrischen Substrat zu realisieren. Es besitzt wenigstens einen Eingangswandler, wenigstens einen Ausgangswandler und gegebenenfalls zusätzliche Strukturen wie insbesondere Reflektorstrukturen. Insbesondere für Resonatorfilter werden derartige Reflektorstrukturen verwendet, wobei insbesondere der Eingangswandler und der Ausgangswandler auch ein und derselbe Wandler sein kann. Um eine bestimmte vorgegebene Übertragungscharakteristik bzw. ein bestimmtes vorgegebenes Resonanzverhalten zu erreichen, ist es bekannt, die als Interdigitalstrukturen ausgebildeten Wandler zu wichten, d.h. mit einer Fingerwichtung (Fingerlängen, Fingerpositions- oder Weglaßwichtung) zu versehen. Ein für die vorliegende Erfindung in Betracht kommender Wandler besteht im Regelfall aus einer Interdigitalstruktur, die aus zwei ineinander verschachtelt angeordneten Kämmen besteht. Ein jeweiliger Kamm besteht dabei aus parallel zueinander angeordneten Fingern, die bei einem Wandler elektrisch mittels einer Sammelschiene (Busbars) verbunden sind. Die Fingerlängenwichtung besteht bekanntlich darin, daß eine mehr oder weniger große Überlappung zwischen einander benachbart angeordneten Fingern vorliegt, wobei jeweils der eine dieser Finger dem einen Kamm zugehört und der andere Finger dem anderen Kamm zugehört. Entsprechendes gilt für Anordnungen mit 'split fingers'. Das Längenmaß der gegenseitigen Überlappung zweier derartiger benachbarter Finger ist ein Maß für die elektroakustische Wirksamkeit dieses Fingerpaares. Benachbarte Finger, von denen der eine zum einen Kamm und der andere zum anderen Kamm gehört, haben Abstände in der Größe einer halben Wellenlänge der zu erzeugenden elastischen akustischen Welle voneinander.

Fig.1      zeigt eine allgemeine Anordnung eines Filters.

Fig.2      zeigt einen Ausschnitt einer Interdigitalstruktur eines Wandlers, wobei dieser Ausschnitt im wesentlichen die Fingerüberlappung zeigt.

Fig.3      zeigt eine Mäanderkurve einer bekannten Ausführungsform einer Überlappungswichtung (Electronics Lett, Vol 8 (20)(1972) S493 Fig.1e).

Fig.4      zeigt eine Ausführungsform der Erfindung.

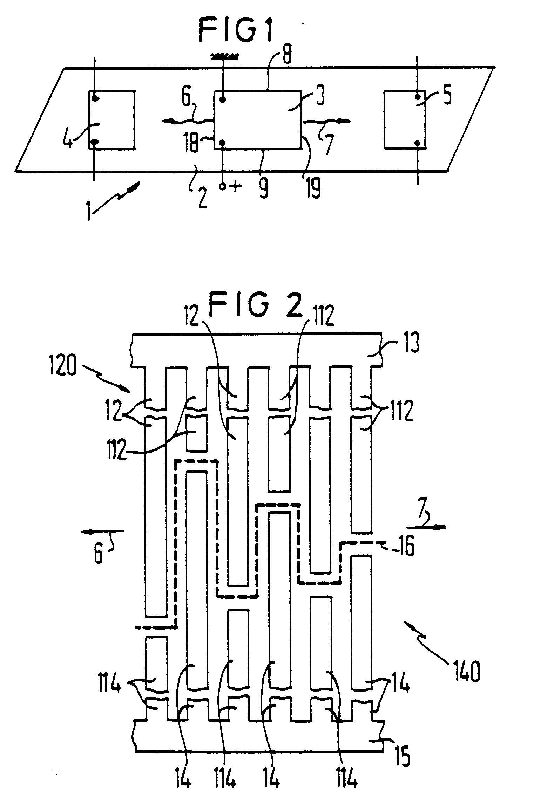

Fig.1 zeigt ein Filter 1 mit auf einem Substrat 2 angeordneten drei Wandlern. Zum Beispiel ist der in der Mitte angeordnete Wandler 3 als Eingangswandler und sind die beiden äußeren Wandler 4 und 5 als gegebenenfalls parallelgeschaltete Ausgangswandler vorgesehen. Von dem Eingangswandler 3 erzeugte elastische Wellen laufen in dem Substrat 2 in den Hauptausbreitungsrichtungen 6 und 7 dieser Wellen zu den Ausgangswandlern 4 und 5.

Zu den hier in Frage kommenden akustischen Wellen gehören die Oberflächenwellen im engeren Sinne (Rayleigh-Wellen; Bleustein-Wellen), nahe der Oberfläche laufende Quer- und Scherwellen (wie Surface Skimming Bulk Waves) sowie auch oberflächennah laufende Anteile von (longitudinal polarisierten) Volumenwellen. Nachfolgend werden diese Wellenarten als Oberflächenwellen (im allgemeineren Sinne verstanden) bezeichnet. Welche Wellenart im Einzelfall erzeugt wird, hängt von dem Fachmann bekannten Maßnahmen der Dimensionierung der Wandler und gegebenenfalls auch von Anisotropie-Eigenschaften des Substrats ab.

In Fig.1 sind die Wandler, insbesondere der Eingangswandler, von dem eine erzeugte akustische Welle ausgesandt wird, mit zueinander parallelen Seitenkanten 8, 9 dargestellt. Dies entspricht parallel zueinander ausgerichteten Sammelschienen (Busbars) und dementsprechend konstanter Breite der Wandlerfläche. Diese konstante Breite ergibt über den ganzen Wandler hinweg konstante Längenabmessung für die Anordnung der Finger. Eine solche Ausführung eines Wandlers hat den Vorteil, daß die von ihm ausgesandten Wellen nicht mit in die Ausbreitungsbahn hineinreichenden Sammelschienen kollidieren, wie dies bei Wandlern mit konvergierenden Sammelschienen nachteiligerweise der Fall ist.

Eine im Eingangswandler 3 erzeugte und entsprechend den Hauptausbreitungsrichtungen 6 und 7 vom Wandler 3 abgestrahlte Welle weist auch bei exakter Ausführung der Interdigitalstruktur des Wandlers Störungen auf. Sie beruhen auf einem Diskontinuitätseffekt, der durch den Umstand gegeben ist, daß die im Wandler erzeugte und von diesem Wandler ausgesandte Welle am Ende des Wandlers denselben verläßt und in freies Substrat übertritt. Es liegt ein abrupter Übergang zwischen der Struktur des Wandlers und der freien Oberfläche des Substrats vor.

Zur Beseitigung solcher Störungen ist seit Jahren eine Maßnahme (z.B. aus der japanischen Patentanmeldung 56-122215A) bekannt, nämlich den Wandler an seinem jeweiligen Ende mit stufenweise kürzer werdenden Fingern auszurüsten, so daß das jeweilige Ende des Wandlers einen stufenweisen Abschluß hat. Die Wirksamkeit dieser Maßnahme hängt im wesentlichen ab von der Feinheit der Abstufung, jedoch ohne daß in der Praxis vollständige Eliminierung des Diskontinuitätseffekts erzielbar ist. Insbesondere hat diese Maßnahme den Nachteil, daß sie nur sehr frequenzselektiv wirksam ist.

Solche Störüngen mit Hilfe eines speziellen Verlaufs der Wichtung zu minimierten, geht aus Electronics Lett. V.8 (20) 1972 Seite 493 Fig.1e hervor.

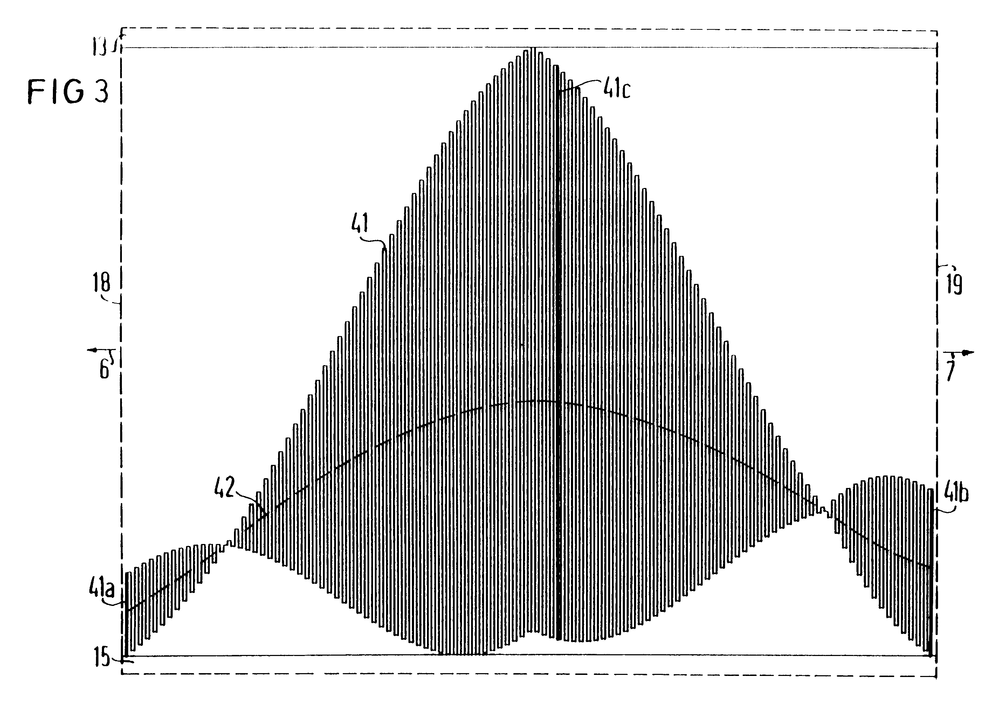

Fig.2 zeigt als Ausschnitt der Interdigitalstruktur eines Wandlers Finger 12 des einen Kammes 120 und Finger 14 des anderen Kammes 140. Die Finger 12 sind mit der einen Sammelschiene 13 und die Finger 14 sind mit der anderen Sammelschiene 15 verbunden. Der Mittenabstand zwischen einem Finger 12 und einem Finger 14 beträgt je nach Ausführung 1/2 Lambda oder 1/4 Lambda der akustischen Wellenlänge. Mit 16 ist eine Mäanderkurve eingezeichnet, deren Weg (in der Fig.2) in Vertikalrichtung entlang bzw. zwischen den Überlappungslängen zweier benachbarter Finger 12 (des einen Kammes) und 14 (des anderen Kammes) verläuft. In Horizontalrichtung verläuft diese Mäanderkurve zwischen einander gegenüberstehenden Fingerenden 12 und 114 bzw. 14 und 112. Die Finger 112 und 114 sind 'dummy'-Finger. Sie sind (weil zwischen jeweils zwei Fingern gleicher Polarität liegend) elektrisch unwirksam, werden aber zur Egalisierung der Struktur verwendet.

Es ist festgestellt worden, daß mit einem Wandler, der eine Fingerüberlappungswichtung hat, die der in Fig.3 dargestellten Mäanderkürve 41 entspricht, oben erwähnte Störungen zu mindern sind, wenn man außerdem dafür sorgt, daß der am jeweiligen Ende 18 und 19 des Wandlers vorhandene letzte Finger der Struktur auf dem Masse-Potential des dem Wandler zugeführten elektrisch unsymmetrischen Signals zugeführt wird. Der erfindungsgemäß ausgestaltete nachfolgend noch näher beschriebene Wandler ist demgemäß ein unsymmetrisch zu betreibender Wandler, wobei dies die weitaus überwiegende Betriebsweise derartiger Wandler ist.

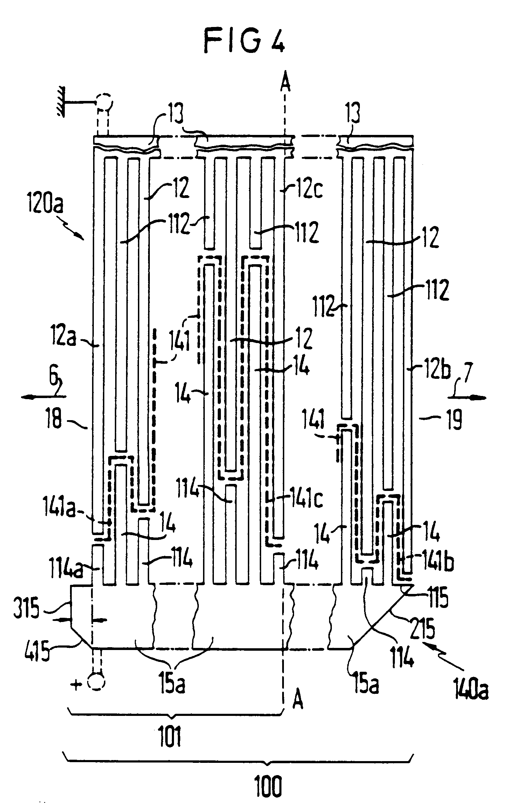

Wie ersichtlich strebt bei einem Wandler (Fig.4) die Mäanderkurve 141 an beiden Wandlerenden 18, 19 ein und derselben, nämlich der erfindungsgemäß der auf Masse liegenden Sammelschiene 13 gegenüberliegenden Sammelschiene 15a zu.

Ein der Mäanderkurve 141 entsprechender Wandler 100 hat an seinen beiden Enden 18 und 19 je einen mit der auf Masse liegenden Sammelschiene 13 verbundenen und zwar überlappenden (aktiven) Finger 12a bzw. 12b, deren Überlappungslänge insbesondere auch gegen Null gehen kann. Bei dem Wandler 100 läßt man jeden dieser beiden auf Masse liegenden Finger 12a und 12b von der Sammelschiene 13 bis möglichst dicht an die gegenüberliegende (nicht auf Massepotential liegende) Sammelschiene 15a des Kammes 140a der Finger 14, 114, 114a heranreichen. Diesem jeweils letzten Fingern 12a, 12b eventuell gegenüberstehende 'dummy' Finger 114a sind möglichst kurz gehalten. Diese Maßnahmen lassen sich durch entsprechende Wahl des Entwurfs (design) für diesen erfindungsgemäß bemessenen Wandler 100 durchführen. Ein erfindungsgemäßer Wandler 100 nutzt die volle, zwischen den zueinander parallelen Sammelschienen 13, 15a gegebene Breite, d.h. hat keine Verringerung seiner Apertur und keine Störungen, die auf in den Ausbreitungspfad der ausgesandten Welle ansonsten hineinreichenden Sammelschienen beruhen.

Dieser zu den Fingern 12a und 12b gegebenen Vorschrift entspricht in Figur 3, nämlich in dem Bild der Mäanderkurve 41, daß die beiden (durch dickeren Strich hervorgehobenen) Enden 41a und 41b der Mäanderkurve 41 bis zu der nicht auf Masse zu legenden Sammelschiene 15a reichen. Entsprechendes gilt für den Wandler 100 der Ausführungsform der Figur 4 hinsichtlich der Enden 141a und 141b der Mäanderkurve 141. Es ist in Figur 4 deutlich zu sehen, wie weit die letzten Finger 12a und 12b des auf Masse liegenden Kammes 120a der gegenüberliegenden Sammelschiene 15a des Kammes 140a nahekommen.

Figur 4 enthält noch eine Variante, nämlich der Wandler 101 soll nur bis zur Linie A reichen. Beim Wandler 101 hat der aktive Finger 12c eine vergleichsweise sehr größe Überlappungslänge, d.h. es endet der Wandler 101 auf dieser Seite mit großer Überlappung der Finger 12c und 14c. Auch beim Wandler 101 sind an seinen beiden Enden die obengenammten Bedingungen erfüllt. Eine dem (verkürzten) Wandler 101 entsprechende Variante ist in Figur 4 eingetragen, nämlich bei der der entsprechend verkürzte Wandler rechtsseitig angenommenerweise mit der Linie 141c der Mäanderkurve 141 endet. Die große Länge der Linie 141c entspricht großer Überlappung (am betreffenden Ende dieses entsprechend verkürzten Wandlers) und dennoch endet die mit der Linie 141c abschließende Mäanderkurve wieder an der Sammelschiene 15a.

Eine solche Ausführung eines Wandlers ergibt - wie festgestellt wurde - ein optimales Ergebnis. Ein sehr gutes Ergebnis wird aber auch noch mit einer solchen Ausführungsform erzielt, bei der am jeweiligen, für die Anwendung der Erfindung in Frage kommenden Ende des Wandlers der letzte Finger 12a, 12b des auf Masse liegenden Kammes wenigstens etwa 80% der gesamtmöglichen Fingerlänge d.h. der Breite des betreffenden Wandlers einnimmt und der dementsprechend gegenüberliegende nicht überlappende (inaktive) 'dummy'-Finger 114a des gegenüberliegenden Kammes (d.h.der Sammelschiene 15a) nicht mehr als die restlichen 20% einnimmt. Vorzugsweise sollte die Länge des jeweils letzten Fingers 12a, 12b bzw. 12c wenigstens 90% des Maximums bzw. der Breite des Wandlers, gemessen zwischen den Sammelschienen 13, 15a, beanspruchen.

Soweit wird Bereits breitbandige Beseitigung der aufgabengemäß noch weiter zu eliminierenden Störungen erzielt.

Es sei ausdrücklich darauf hingewiesen, daß die vorliegende Lehre keineswegs auf Übertragungsfunktionen mit Minima und inbesondere Null-Stellen der Fingerüberlappung innerhalb der Struktur beschränkt ist. Die Erfindung ist auch bei sich entsprechend der vorgegebenen Übertragungsfunktion ergebenden Wandlern realisierbar, die z.B. an einem oder an beiden Enden Null-Stellen dem Fingerüberlappung haben, überhaupt keine Null-Stellen haben, nur in der einen oder in der anderen Richtung konvergierende Mäanderkurve und dergleichen haben. Es besteht keinerlei Erfordernis, die realisierte Interdigitalstruktur so auszuführen, daß Konvergenz der Sammelschienen zum einen oder zu beiden Enden des betreffenden Wandlers hin vorliegt, wie dies z.B. in der Anfangsphase der Entwicklung solcher Filter häufig praktiziert wurde. Solche Ausführungsformen sind nämlich, wie oben erwähnt, nachteilig.

Diese Lehre läßt sich sinngemäß auch bei Strukturen mit 'split fingers' anwenden.

Die noch nachfolgend beschriebene Erfindung ist vorgesehen für fingerlängengewichtete Wandlerstrukturen, bei denen keiner der beiden Wandlerkämme 120, 140 einzeln für sich nicht nur lediglich gleichlange aktive (überlappende) Finger (12 bzw. 14) hat (bzw. beide Kämme längengewichtet sind). Bei einer dementsprechend ausgeschlossenen Struktur ist nämlich die Freiheit der Wahl des Entwurfs stark eingeschränkt und wäre die mit einer solchen einseitigen Fingerwichtung verbundene Beugung nicht ausreichend wirksam zu kompensieren.

Zur vorliegenden Erfindung gehört noch ein weiteres Merkmal. Es liegt nämlich im Rahmen der Praxis, daß die Sammelschiene (Busbar) der jeweiligen Kammstruktur eine rechteckige Fläche einnimmt und eine Breite hat, die bis zu z.B. 5 bis 10% der Längenabmessung des Abstandes zwischen den einander gegenüberliegenden beiden Sammelschienen der zwei Kammstrukturen, d.h. der Abmessung der maximal möglichen Fingerlänge hat. Es liegt also quer zur jeweiligen Hauptausbreitungsrichtung, d.h. parallel zu den Fingern, am jeweiligen rechteckigen Ende der betreffen Interdigitalstruktur eine der Breite der Sammelschiene entsprechende scheinbare Verlängerung des bzw. der jeweils letzten Finger vor.

Aufgabe der vorliegenden Erfindung ist es eine noch weitere Verringerung von bei einem wie voranstehend beschriebenen Filter beobachteten Störungen zu erreichen.

Diese Aufgabe wird mit den Merkmalen des Anspruchs 1 gelöst und Anspruch 2 betrifft dazu einen Spezialfall.

Eine wie in Figur 4 an der rechteckigen Sammelschiene 13 gezeigte (nach rechts und nach links) stirnseitige Kante der Sammelschiene hätte, wie festgestellt wurde, bei der auf hohem Potential liegenden Sammelschiene (es wäre hier dies die Sammelschiene 15a) eine Wirkung, als würde dann dort jeweils noch ein Stück Finger bzw. eine Fingerlänge vorliegen. Es kann dadurch eine wesentliche Störung hervorgerufen sein, insbesondere dann, wenn die Sammelschiene 15a eine noch größere Breite als dargestellt hat, was in vielen Fällen vorliegt.

Figur 4 zeigt auch die kennzeichnenden Merkmale der Erfindung. Maßstäblich zum Abstand zwischen den Sammelschienen 13 und 15a ist die Sammelschiene 15a mit einer für viele Fälle realistischen Breite wiedergegeben. An der linken, unteren Ecke des Interdigitalwandlers nach Figur 4 ist die Breite der Sammelschiene 15a wenigstens so groß wie der inaktive Finger 114a lang ist. Der Entwurf zu dem Interdigitalwandler nach den der Figur 4 ist zwar so gewählt, daß die Fingerlänge des inaktiven Fingers 114a möglichst kurz ist, d.h. daß das Teil 141a der Mäanderkurve möglichst nahe der Sammelschiene 15 kommt. Noch mehr ins Gewicht fällt die Breite der Sammelschiene 15a an der rechten unteren Ecke des Interdigitalwandlers der Figur 4. Dort ist keine (114a vergleichbare) tatsächliche Fingerlänge auf hohem Potential vorhanden und dennoch liegt keine entsprechende störende Wirkung in Richtung der Hauptausbreitungsrichtung 7 vor.

In Figur 4 ist eine Abschrägung 215 des rechtsseitigen Endes der Sammelschiene 15a angegeben. Diese Abschrägung 215 beseitigt die in der Hauptausbreitungsrichtung 7 ansonsten auftretende, störende Wirkung der ansonsten senkrechten Kante einer Sammelschiene. Es sei darauf hingewiesen, daß der Maßstab in senkrechter Richtung der Figur 4 stark verzerrt ist gegenüber dem Maßstab in Querrichtung der Figur 4. Der in waagerechter Richtung in Figur 4 erkennbare Vorsprung 115 an der spitzen Ecke der Abschrägung 215 beträgt in Wirklichkeit nur wenige μm. Dieser waagerechte Vorsprung gegenüber dem rechtsseitig letzten Finger 14 beträgt etwa 1% der Breite der Sammelschiene 15a. Für diese Abschrägung 215 ist ein Winkel gegenüber der Waagerechten vorzusehen, der dazu führt, daß eine Abstrahlung aus der Bahn herausgelenkt ist.

An der linken unteren Ecke des Interdigitalwandlers der Figur 4 ist eine zweite Ausgestaltung angegeben. Dort ist durch Versatz der linksseitigen Stirnkante der Sammelschiene 15a, d.h. durch die Lage der Kante 315 ein Kompensationseffekt bewirkt. Der Anteil 415 der Breite der Sammelschiene 15a, der für die vorgesehene Kompensation nicht benötigt wird, weist eine der Abschrägung 215 entsprechende Abschrägung 415 auf.

Mit dem Versatz der stirnseitigen Kante 315, die parallel zur Kante des Fingers 114 verläuft, wird eine Kompensation der restlichen Abstrahlwirkung des Fingers 114a bewirkt, und zwar dann, wenn dieser Versatz das (2n-1)-fache der halben Wellenlänge Lambda der von dem Interdigital-Wandler ausgesandten akustischen Welle ist (n = 1,2,3...), jedoch vorzugsweise n = 1. Die Kompensation wird durch Interferenz bewirkt. Zu dieser Interferenz nicht erforderlicher Anteil 415 der Breite der Sammelschiene 15a ist, wie oben erwähnt, abgeschrägt ausgeführt.

**Patentansprüche**

1. Mit akustischen Wellen arbeitendes elektrisches Filter mit einer als Wandler (100; 101) dienenden Interdigitalstruktur mit miteinander überlappenden (aktiven), ineinander greifenden Fingern (12, 14) zweier Kammstrukturen (120a, 140a) mit jeweiliger Sammelschiene (13, 15a), wobei bei diesem Wandler Verminderung der Störungen erzielt ist, die auf dem Diskontinuitätseffekt der Wellenausbreitung am Ende (18, 19) des Wandlers beruhen,
wobei die Fingerüberlappungen einer Fingerlängen-Überlappungswichtung entsprechen, die einer vorgegebenen Übertragungsfunktion genügt und eine diese Wichtung repräsentierende Mäanderkurve (141) anzugeben ist,
wobei die Sammelschienen der zwei Kammstrukturen parallel zueinander verlaufen und wobei die Überlappung am Ende (18, 19) des Wandlers derart ist, daß dort die Mäanderkurve nahe der einen Sammelschiene (15a) endet,
**gekennzeichnet dadurch,**
daß diese eine Sammelschiene die auf hohes Potentials des unsymetrisch zu betreibenden Wandlers (100; 101) zu legende Sammelschiene (15a) ist, so daß am Wandlerende (18, 19) der letzte der überlappenden (aktiven) Finger (12a, 12b; 12c) ein Finger der auf Masse liegenden Kammstruktur (120a) des Wandlers (100; 101) ist und die Überlappungslänge dieses letzten Fingers (12a, 12b; 12c) die dieser mit dem entsprechenden überlappenden (aktiven) Finger (14) der anderen Kammstruktur (140a) hat, auch gegen den Wert 0 gehen kann und daß das Ende dieser einen auf hohem Potential liegenden Sammelschiene (15a) eine Abschrägung (215, 415) aufweist,
deren Ausmaß so bemessen ist, daß sie diejenige Maß der auf die Senkrechte zur Hauptausbreitungsrichtung der Welle bezogenen Breite dieser Sammelschiene (15a) erfaßt, um das diese Sammelschiene (15a) breiter ist als das Längenmaß desjenigen mit dieser Sammelschiene (15a) verbundenen, nicht überlappenden (inaktiven) Fingers (114a), der dem letzten Finger (12a, 12b; 12c) der auf Massepotential liegenden Kammstruktur (120a) gegenübersteht, wobei die restliche Breite des stirnseitigen Endes dieser auf hohem Potential liegenden Sammelschiene (15a) gegenüber der Außenkante dieses dort letzten nichtüberlappenden Fingers (114a) mit seiner Außenkante (315) derart versetzt ist, daß der Versatz zwischen der Außenkante dieses letzten nichtüberlappenden Fingers (114a) und dieser Außenkante (315) der Sammelschiene (15a) wenigstens angenähert (2n-1) x 1/2 Lamda beträgt, worin Lamda die Wellenlänge der in Hauptausbreitungsrichtung (6, 7) ausgesandten akustischen Welle des Wandlers ist und n eine ganze Zahl (1, 2, 3...) ist.

2. Filter nach Anspruch 1,
**gekennzeichnet dadurch,**
daß bei fehlendem, dem letzten Finger (12a, 12b; 12c) der auf Masse liegenden Kammstruktur (120a) gegenüberstehendem, nichtüberlappendem Finger (114a) die Abschrägung (215) der auf hohem Potential liegenden Sammelschiene (15a) deren gesamte Breite erfaßt.

**Claims**

1. Electrical filter operating with acoustic waves, comprising an interdigital structure, serving as transducer (100; 101), having mutually overlapping (active) intermeshing fingers (12, 14) of two comb structures (120a, 140a) with a bus (13, 15a) in each case, and this transducer effecting a reduction in the disturbances due to the discontinuity effect of the wave propagation at the end (18, 19) of the transducer, the finger overlaps corresponding to a finger length overlap weighting which satisfies a predetermined transfer function and a meander curve (141) representing this weighting having to be specified, the buses of the two comb structures extending in parallel with one another and the overlap at the end (18, 19) of the transducer being such that the meander curve ends there close to one bus (15a), characterised by the fact that this one bus is the bus (15a) to be placed at high potential of the transducer (100; 101) to be operated asymmetrically so that at the transducer end (18, 19), the last of the overlapping (active) fingers (12a, 12b; 12c) is a finger of the comb structure (120a) of the transducer (100; 101) connected to earth and the length of overlap of this last finger (12a, 12b; 12c), which the finger has with the corresponding overlapping (active) finger (14) of the other comb structure (140a) can also tend towards the value 0 and that the end of this one bus (15a) at high potential exhibits a bevel (215, 415) the extent of which is dimensioned in such a manner that it covers the dimension of the width of this bus (15a) referred to the perpendicular with respect to the main direction of propagation of the wave, by which dimension this bus (15a) is wider than the longitudinal dimension of the non-overlapping (inactive) finger (114a) which is connected to this bus (15a) and which is opposite to the last finger (12a, 12b; 12c) of the comb structure (120a) at earth potential, the remaining width of the extremity at the front end of this bus (15a) at high potential is offset with respect to the outer edge of this non-overlapping finger (114a), which is the last one there, with its outer edge (315) in such a manner that between the outer edge of this last non-overlapping finger (114a) and this outer edge (315) of the bus (15a) the offset is at least approximately (2n-1) x 1/2 lambda, where lambda is the wavelength of the acoustic wave of the transducer sent out in the main direction of propagation (6, 7) and n is an integral number (1, 2, 3 ...).

2.  Filter according to Claim 1, characterised by the fact that when the non-overlapping finger (114a) opposite to the last finger (12a, 12b; 12c) of the comb structure (120a) at earth is missing, the bevel (215) of the bus (15a) at high potential covers the entire width of the said bus.

**Revendications**

1.  Filtre électrique opérant avec des ondes acoustiques et possédant une structure interdigitée utilisée comme transducteur (100;101) et comportant deux structures en forme de peignes (120a,140a) comprenant des doigts (12,14) qui se chevauchent réciproquement (actifs) et s'interpénètrent, et comportant des barres collectrices respectives (13,15a), et dans lequel dans chaque transducteur on obtient une réduction des parasites, qui sont basés sur l'effet de discontinuité de la propagation des ondes à l'extrémité (18,19) du transducteur, et dans lequel

les chevauchements des doigts correspondent à une direction de chevauchement des longueurs des doigts, qui est suffisante pour une fonction prédéterminée de transmission, et une courbe sinueuse (141) représentant cette pondération qui doit être indiquée,

les barres collectrices des deux structures en forme de peignes sont parallèles entre elles, et le chevauchement à l'extrémité (18,19) du transducteur est tel qu'en cet endroit la courbe sinueuse se termine à proximité de l'une (15a) des barres collectrices,

caractérisé par le fait

que cette barre collectrice est la barre collectrice (15a), qui doit être placée à un potentiel élevé du transducteur (100; 101), qui doit fonctionner de façon dissymétrique, de sorte qu'à l'extrémité (18,19) du transducteur, le dernier des doigts en chevauchement (actifs) (12a,12b; 12c) est un doigt de la structure en forme de peigne (120a), raccordée à la masse, du transducteur (100,101) et que la longueur de chevauchement de ce dernier doigt (12a,12b;12c), sur laquelle ce doigt est en chevauchement avec le doigt en chevauchement correspondant (actif) (14) de l'autre structure en forme de peigne (140a), peut tendre également vers la valeur 0 et que l'extrémité de cette barre collectrice (15a) placée à un potentiel élevé possède un biseau (215,415), dont la taille est dimensionnée de manière à s'étendre sur la distance dans le sens de la largeur, rapportée à la perpendiculaire de la direction de propagation principale de l'onde, dont la longueur de cette barre collectrice (15a) est supérieure à la longueur du doigt non en chevauchement (inactif) (114a), qui est raccordé à cette barre collectrice (15a), et qui est en vis-à-vis du dernier doigt (12a,12b;12c) de la structure en forme de peigne (120a) raccordée au potentiel de masse, le bord extérieur (315) de la partie restante en largeur de l'extrémité frontale de cette barre collectrice (15a) placée à un potentiel élevé étant décalé par rapport au bord extérieur de ce dernier doigt non en chevauchement (114a) de sorte qu'entre le bord extérieur de ce dernier doigt non en chevauchement (114a) et ce bord extérieur (315) de la barre collectrice (15a) existe une distance égale au moins approximativement à (2n-1) fois 1/2 lambda, lambda étant la longueur d'onde de l'onde acoustique du transducteur émise dans la direction de propagation principale (6,7), et n un nombre entier (1,2,3,...).

2. Filtre suivant la revendication 1, caractérisé par le fait que, dans le cas où l'absence d'un doigt non en chevauchement (114a) situé en vis-à-vis du dernier doigt (12a,12b;12c) de la structure en forme de peigne (120a) raccordée à la masse, le biseau (215) de la barre collectrice (15a) placée à un potentiel élevé s'étend sur toute la largeur de cette barre.

# FIG 1

# FIG 2

FIG 3

EP 0 179 459 B1

FIG 4